# EUROPEAN PATENT APPLICATION

(11) **EP 4 739 022 A1**
(43) Date of publication of application: **06.05.2026**
(21) Application number: 25210369.2
(22) Date of filing: 22.10.2025
(51) Int. Cl.: H10B 12/00

(54) **SEMICONDUCTOR DEVICE INCLUDING ACTIVE PORTION AND BIT LINE**

(30) Priority: 31.10.2024 KR 20240152823
(71) Applicant: Samsung Electronics Co., Ltd., Suwon-si, Gyeonggi-do 16677 (KR)
(72) Inventor: HAN, Eunshoo, 16677 Suwon-si, Gyeonggi-do (KR); PARK, Chanhoon, 16677 Suwon-si, Gyeonggi-do (KR); JEON, Hayoung, 16677 Suwon-si, Gyeonggi-do (KR)
(74) Representative: Kuhnen & Wacker Patent- und Rechtsanwaltsbüro PartG mbB

(57) **Abstract**

Provided is a semiconductor device including: a first active portion (AF1); an isolation region (STI) on a side surface of the first active portion (AF1); and a bit line (BL) connected to the first active portion (AF1), wherein the first active portion (AF1) includes a first region (AP1) in contact with the isolation region (STI) and a second region (AP2) extending upwardly from the first region (AP1), wherein the second region (AP2) is spaced apart from the isolation region (STI), and wherein the bit line (BL) includes: a line portion (LP) extending in a horizontal direction (Y); and a contact portion (CP) below the line portion (LP), wherein the contact portion (CP) is connected to the second region (AP2) of the first active portion (AFI).

## Description

### BACKGROUND

The present disclosure relates to a semiconductor device including an active portion and a bit line and a method for forming the semiconductor device.

Research is being conducted to reduce the size of elements constituting a semiconductor device and to improve the performance thereof. For example, in a DRAM, research is being conducted to reliably and stably form reduced-size elements.

### SUMMARY

Provided is a semiconductor device for increasing a degree of integration.

Further provided is a semiconductor device for improving reliability.

Further provided is a method for manufacturing a semiconductor device that can increase a degree of integration and improve reliability.

According to an aspect of the disclosure, a semiconductor device includes: a first active portion; an isolation region on a side surface of the first active portion; and a bit line connected to the first active portion, wherein the first active portion includes a first region in contact with the isolation region and a second region extending upwardly from the first region, wherein the second region is spaced apart from the isolation region, and wherein the bit line includes: a line portion extending in a first horizontal direction; and a contact portion below the line portion, wherein the contact portion is connected to the second region of the first active portion.

According to an aspect of the disclosure, a semiconductor device includes: a first active portion; a second active portion adjacent to the first active portion; an isolation region between the first active portion and the second active portion; a bit line connected to the first active portion; a contact structure connected to the second active portion; and a data storage structure connected to the contact structure, wherein the first active portion includes an upper surface, wherein the upper surface of the first active portion is upwardly convex, and wherein the bit line includes: a contact portion contacting the upper surface of the first active portion; and a line portion on the contact portion, the line portion extending in a first horizontal direction.

According to an aspect of the disclosure, a semiconductor device includes: active regions; an isolation region between the active regions; gate structures extending across the active regions and into the isolation region; and bit lines connected to the active regions, wherein each of the active regions includes a first active portion and a second active portion, wherein the first active portion and the second active portion of each respective active region of the active regions are spaced apart from each other by a gate structure crossing the respective active region from among the gate structures, wherein the active regions include a first active region, wherein the bit lines include a first bit line connected to the first active portion of the first active region, wherein the first active portion of the first active region includes: a first region including a side surface in contact with the isolation region; and a second region extending upwardly from the first region, the second region being spaced apart from the isolation region, and wherein the first bit line includes: a line portion extending in a first horizontal direction; and a contact portion below the line portion and connected to the second region of the first active portion.

### BRIEF DESCRIPTION OF DRAWINGS

The above and other aspects and features of certain embodiments of the present disclosure will be more clearly understood from the following detailed description, taken in conjunction with the accompanying drawings, in which:
FIG. 1A is a plan view illustrating a semiconductor device according to one or more embodiments of the present disclosure;
FIG. 1B is a plan view illustrating some elements of FIG. 1A;
FIG. 2A is a cross-sectional view illustrating a region taken along line I-I' of FIG. 1A;
FIG. 2B is a partial enlarged view illustrating a region indicated by "A" in FIG. 2A.
FIG. 3 is a cross-sectional view illustrating a region taken along line II-II' of FIG. 1A;
FIGS. 4A and 4B are drawings illustrating a semiconductor device according to one or more embodiments of the present disclosure;
FIGS. 5A and 5B are drawings illustrating a semiconductor device according to one or more embodiments of the present disclosure;
FIGS. 6A and 6B are drawings illustrating a semiconductor device according to one or more embodiments of the present disclosure; and
FIGS. 7, 8, 9, 10, 11, 12, 13, 14, 15 and 16 are drawings illustrating an example of a method for forming a semiconductor device according to one or more embodiments of the present disclosure.

### DETAILED DESCRIPTION

Hereinafter, terms such as "upper," "intermediate," and "lower" may be replaced with other terms, such as "first," "second," and "third," to describe elements of the specification. Although the terms "first," "second," and "third" may be used to describe various elements, the elements are not limited by the terms, and a "first element" may be referred to as a "second element." The reference numerals BL (BL1) and BL (BL2) shown in the drawings may be described as indicating that the element referred to as "BL" includes the element referred to as "BL1" and the element referred to as "BL2". A size ratio, width ratio, length ratio, and the like, between the elements depicted in the drawing can be understood from the elements depicted in the drawing even without a separate explanation.

In the following description, like reference numerals refer to like elements throughout the specification.

It will be understood that when an element is referred to as being "connected" with or to another element, it can be directly or indirectly connected to the other element.

Also, when a part "includes" or "comprises" an element, unless there is a particular description contrary thereto, the part may further include other elements, not excluding the other elements.

Throughout the description, when a member is "on" another member, this includes not only when the member is in contact with the other member, but also when there is another member between the two members.

As used herein, the expressions "at least one of a, b or c" and "at least one of a, b and c" indicate "only a," "only b," "only c," "both a and b," "both a and c," "both b and c," and "all of a, b, and c."

As used herein, the singular forms "a," "an" and "the" are intended to include the plural forms as well, unless the context clearly indicates otherwise.

With regard to any method or process described herein, an identification code may be used for the convenience of the description but is not intended to illustrate the order of each step or operation. Each step or operation may be implemented in an order different from the illustrated order unless the context clearly indicates otherwise. One or more steps or operations may be omitted unless the context of the disclosure clearly indicates otherwise.

The various actions, acts, blocks, steps, or the like in the flow diagrams may be performed in the order presented, in a different order, or simultaneously. Further, in one or more embodiments, some of the actions, acts, blocks, steps, or the like may be omitted, added, modified, skipped, or the like without departing from the scope of the disclosure.

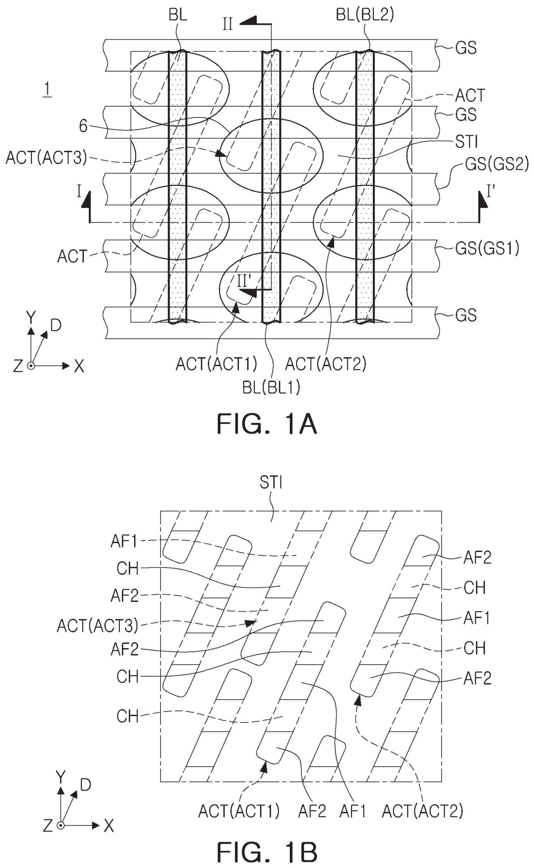

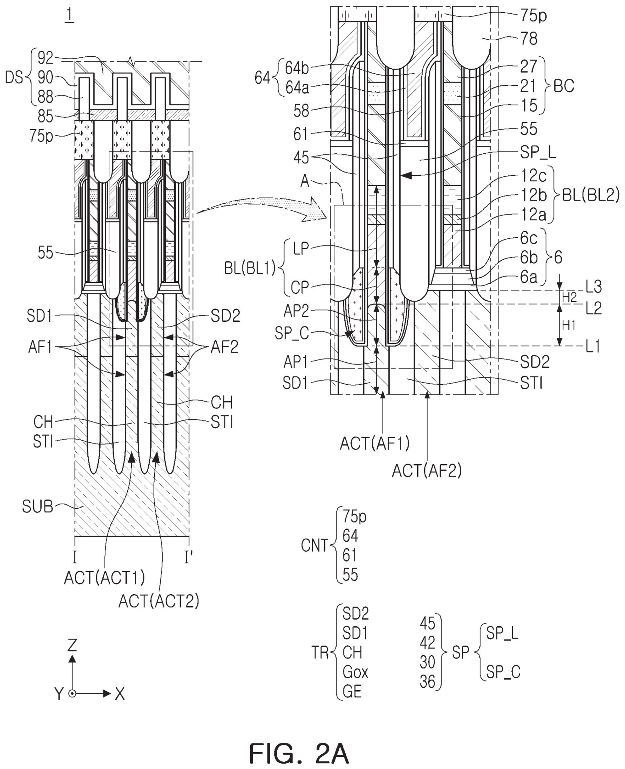

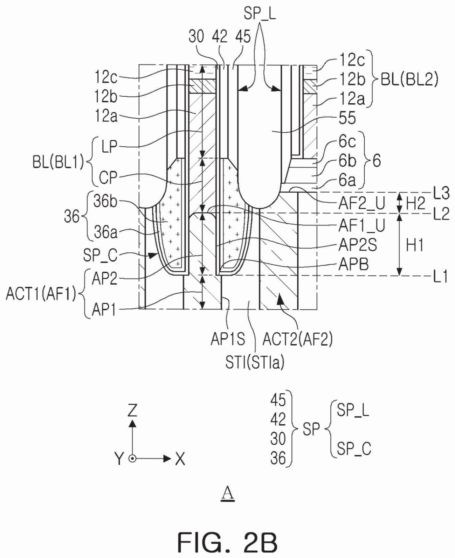

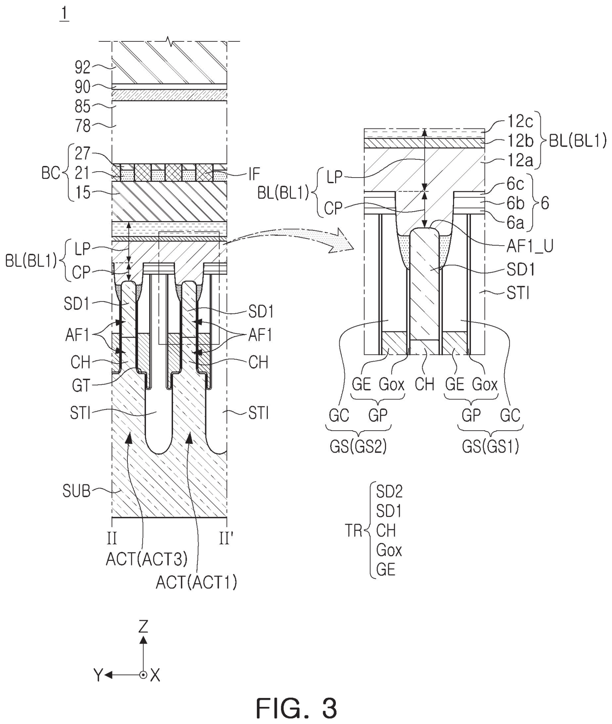

An exemplary example of a semiconductor device according to one or more embodiments of the present disclosure will be described with reference to FIGS. 1A, 1B, 2A, 2B, and 3. FIG. 1A is a plan view illustrating a semiconductor device according to one or more embodiments of the present disclosure, and FIG. 1B is a plan view illustrating some elements of FIG. 1A. FIG. 2A is a cross-sectional view illustrating a region taken along line I-I' of FIG. 1, and FIG. 2B is a partial enlarged view illustrating a region indicated by "A" in FIG. 2A. FIG. 3 is a cross-sectional view illustrating a region taken along line II-II' of FIG. 1A.

Referring to FIGS. 1A, 1B, 2A, 2B, and 3, a semiconductor device 1 according to one or more embodiments may include a substrate SUB, active regions ACT, an isolation region STI, bit lines BL, and insulating spacer structures SP.

The substrate SUB may be a semiconductor substrate. The substrate SUB may be provided as a bulk wafer, an epitaxial layer, a Silicon On Insulator (SOI) layer, or a Semiconductor On Insulator (SeOI) layer. The substrate SUB may include a group IV semiconductor, a group III-V compound semiconductor, or a group II-VI compound semiconductor. For example, the substrate SUB may be a substrate comprising at least one of silicon, silicon carbide, germanium, or silicon-germanium. For example, the substrate SUB may be a single crystal silicon substrate comprising a silicon material, for example, a single crystal silicon material.

The active regions ACT may be disposed on the substrate SUB. The active regions ACT may have a shape protruding in a vertical direction Z from the substrate SUB. The active regions ACT may be formed of the same semiconductor material as the substrate SUB, for example, single crystal silicon. Each of the active regions ACT may have a bar shape extending in a D-direction. The isolation region STI may define the active regions ACT on the substrate SUB. The isolation region STI may be disposed on the side surfaces of the active regions ACT. The isolation region STI may be disposed between the active regions ACT. The isolation region STI may be formed of an insulating material including at least one of silicon oxide and silicon nitride.

The semiconductor device 1 may further include gate structures GS extending across the active regions ACT and into the isolation region STI. The gate structures GS may be disposed in the gate trenches GT extending across the active regions ACT and into the isolation region STI. Each of the gate structures GS may have a line shape extending in an X-direction.

Each of the gate structures GS may include a gate pattern GP and a gate capping layer GC.

Each of the gate patterns GP may include a gate dielectric layer Gox and a gate electrode GE. In each of the gate structures GS, the gate dielectric layer Gox may be disposed on an inner wall of the gate trench GT, and the gate electrode GE may partially fill the gate trench GT on the gate dielectric layer Gox. The gate capping layer GC can fill the remaining portion of the gate trench GT on the gate electrode GE. The gate electrode GE and the gate capping layer GC may be sequentially stacked. The gate dielectric layer Gox may be disposed between a bottom surface of the gate electrode GE and a bottom surface of the gate trench GT, between a side surface of the gate electrode GE and a side wall of the gate trench GT, and between a side surface of the gate capping layer GC and a side wall of the gate trench GT.

Each of the active regions ACT may include active portions AF1 and AF2 spaced apart from each other by the gate structures GS.

Among the gate structures GS, a pair of gate structures GS, adjacent to each other, may cross one active region ACT. Thus, one active region ACT may include active portions AF1 and AF2 spaced apart from each other by the pair of gate structures GS. In the one active region ACT, the active portions AF1 and AF2 may include a first active portion AF1 disposed between the pair of gate structures GS, and second active portions AF2 disposed on the exterior of the pair of gate structures GS. For example, among the gate structures GS, the first gate structure GS1 and the second gate structure GS2, adjacent to each other may cross a first active region ACT1 among the active regions ACT, and the first active region ACT1 may include a first active portion AF1 and second active portions AF2 spaced apart from each other by the first and second gate structures GS1 and GS2. Accordingly, each of the active regions ACT may include second active portions AF2 spaced apart from each other in the D-direction, and a first active portion AF1 between the second active portions AF2.

The active regions ACT may include a first active region ACT1, a second active region ACT2, and a third active region ACT3.

The first active region ACT1 and the second active region ACT2 may be adjacent to each other in an X-direction (separated by isolation layer STI). The first active region ACT1 and the third active region ACT3 may be adjacent to each other in a Y-direction (again separated by isolation layer STI).

The X-direction and the Y-direction may be horizontal directions that are parallel to an upper surface of the substrate SUB and perpendicular to each other. The D-direction may be a diagonal direction that is parallel to the upper surface of the substrate SUB. The Y-direction may be referred to as a first horizontal direction, the X-direction may be referred to as a second horizontal direction, and the D-direction may be referred to as a diagonal direction. As noted above, the Z-direction may also be referred to herein as a vertical direction.

On a plane such as FIG. 1B, the first active portion AF1 of the first active region ACT1 may be adjacent to a second active portion AF2 disposed lower among the second active portions AF2 of the second active region ACT2 in the X-direction. On a plane such as FIG. 1B, a second active portion AF2 disposed higher in the X-direction among the second active portions AF2 of the first active region ACT1 may be disposed between a second active portion AF2 disposed higher among the second active portions AF2 of the second active region ACT2 in the X-direction and a second active portion AF2 disposed lower among the second active portions AF2 of the third active region ACT3.

An upper surface AF2_U of the second active portion ACT2(AF2) may be disposed on a higher level (i.e., farther from the substrate SUB) than an upper surface AF1_U of the first active portion ACT1(AF1).

In one or more embodiments, the upper surface AF1_U of the first active portion ACT1(AF1) may have an upwardly convex shape (i.e., is convex on a side facing away from substrate SUB).

In one or more embodiments, the upper surface AF2_U of the second active portion ACT2(AF2) may have a substantially flat shape.

In each of the active regions ACT, the first active portion AF1 may include a first region AP1 contacting the isolation region STI and a second region AP2 extending upwardly in a Z-direction from the first region AP1 and spaced apart from the isolation region STI.

In one or more embodiments, a vertical thickness of the second region AP2 may be greater than a width (e.g. in the X-direction) of the second region AP2.

In each of the active regions ACT, a side surface of the first active portion AF1 may include a first side surface AP1S of the first region AP1, a second side surface AP2S of the second region AP2, and a bent portion APB between the first side surface AP1S and the second side surface AP2S. The bent portion APB may be a region which is bent from the first side surface AP1S and the second side surface AP2S.

The bent portion APB may be disposed at a first level L1, the upper surface AF1_U of the first active portion ACT1(AF1) may be disposed at a second level L2, and the upper surface AF2_U of the second active portion ACT2(AF2) may be disposed at a third level L3.

In one or more embodiments, a height difference H1 between the first level L1 and the second level L2 may be greater than a height difference H2 between the second level L2 and the third level L3.

Each of the active regions ACT may include a first source/drain region SD1 disposed within an upper region of the first active portion AF1, second source/drain regions SD2 disposed within upper regions of the second active portions AF2, and channel regions CH disposed within lower regions of the first and second active portions AF1 and AF2 and within the active region ACT below the gate structures GS. Each of the channel regions CH may be disposed below a lower surface of one gate structure GS and within the first and second active portions AF1 and AF2 disposed on both sides of the gate electrode GE of one gate structure GS.

The gate dielectric layer Gox, the gate electrode GE, the first source/drain region SD1, the channel region CH, and the second source/drain region SD2 may form a transistor TR.

The semiconductor device 1 may further include bit lines BL and insulating spacer structures SP.

Each of the bit lines BL may include a line portion LP extending in the Y-direction and contact portions CP disposed below the line portion LP and respectively connected to the first active portions AF1.

The contact portion CP may be electrically connected to an upper surface AF1_U of the first active portion AF1. The contact portion CP may be in contact with the upper surface AF1_U of the first active portion AF1. A vertical length of the contact portion CP may be equal to or less than a vertical length of the second region AP2. Here, the vertical length may be the thickness in the vertical direction Z.

A width of the contact portion CP in the X-direction may be substantially the same as a width of the second region AP2 of the first active portion AF1 in the X-direction. As illustrated in FIG. 2B, a side surface of the contact portion CP in the X-direction may be aligned with a side surface AP2S of the second region AP2 of the first active portion AF1 in the X-direction.

The width of the contact portion CP in the X-direction may be smaller than the width of the first region AP1 of the first active portion AF1 in the X-direction.

The width of the contact portion CP in the Y-direction may be greater than the width of the second region AP2 of the first active portion AF1 in the Y-direction. The width of the contact portion CP in the Y-direction may be greater than the width of the first region AP1 of the first active portion AF1 in the Y-direction.

The line portion LP may include at least one conductive layer. For example, the line portion LP may include a first conductive layer 12a, a second conductive layer 12b, and a third conductive layer 12c that are sequentially stacked. The first to third conductive layers (12a, 12b, and 12c) may include different materials. The first conductive layer 12a may include doped silicon. For example, the first conductive layer 12a may include at least one of doped polysilicon and doped epitaxial silicon. The second conductive layer 12b may include at least one of TiN, TaN, WN, NbN, TiAl, TiAlN, TiSi, TiSiN, TaSi, TaSiN, RuTiN, NiSi, and CoSi. The third conductive layer 12c may include at least one of Al, Cu, Ti, Ta, Ru, W, Mo, Pt, Ni, and Co.

Each of the contact portions CP may extend from the line portion LP. For example, each of the contact portions CP may extend from the first conductive layer 12a of the line portion LP. Therefore, the contact portions CP may be formed of the first conductive layer 12a.

The isolation region STI may include an isolation region STIa disposed between the first active portion AF1 of the first active region ACT1 and the second active portion AF2 of the second active region ACT2. The isolation region STIa may further include a portion between the contact spacer SP_C and the second active portion AF2. The isolation region STIa of the isolation region STI may be disposed between the first active portion AF1 of the first active region ACT1 and the second active portion AF2 of the second active region ACT2 and may extend between the contact spacer SP_C and the second active portion AF2.

The semiconductor device 1 may further include a buffer insulating structure 6 on the active regions ACT, the isolation region STI, and the gate structures GS. The buffer insulating structure 6 may include at least one insulating material. For example, the buffer insulating structure 6 may include a first insulating layer 6a, a second insulating layer 6b, and a third insulating layer 6c that are sequentially stacked. The first and third insulating layers 6a and 6c may include silicon oxide, and the second insulating layer 6b may include silicon nitride.

The line portions LP of the bit lines BL may be disposed on the buffer insulating structure 6.

The semiconductor device 1 may further include bit line capping patterns BC on the bit lines BL.

Each of the bit line capping patterns BC may include an insulating material such as silicon nitride. Each of the bit line capping patterns BC may include at least one insulating material layer. For example, each of the bit line capping patterns BC may include a first insulating material layer 15, a second insulating material layer 21 on the first insulating material layer 15, and a third insulating material layer 27 on the second insulating material layer 21. In each of the bit line capping patterns BC, a thickness of the second insulating material layer 21 may be smaller than a thickness of each of the first and third insulating material layers 15 and 27.

The semiconductor device 1 may further include insulating spacer structures SP. Each of the insulating spacer structures SP may include a contact spacer SP_C and a line spacer SP_L.

The contact spacer SP_C may be disposed on a side surface of the second region AP2 of the first active portion AF1 and a side surface of the contact portion CP of the bit line BL. The contact spacer SP_C may be in contact with the side surface of the second region AP2 of the first active portion AF1 and the side surface of the contact portion CP of the bit line BL.

The line spacer SP_L may be disposed on a side surface of the line portion LP of the bit line BL and a side surface of the bit line capping pattern BC. The line spacer SP_L may be in contact with the side surface of the line portion LP of the bit line BL and the side surface of the bit line capping pattern BC. A width of the line spacer SP_L may be smaller than a width of the contact spacer SP_C.

Each of the insulating spacer structures SP may include an inner spacer 30, an intermediate spacer 42, an outer spacer 45, and a plug spacer 36.

The intermediate and outer spacers 42 and 45 may be disposed on a side surface of the line portion LP of the bit line BL and a side surface of the bit line capping pattern BC.

The plug spacer 36 may be disposed on the side surface of the contact portion LP of the bit line BL. The plug spacer 36 may include a spacer pattern 36b and a spacer liner 36a covering a side surface and a lower surface of the spacer pattern 36b.

The inner spacer 30 may be disposed between a side surface of the bit line capping pattern BC and the intermediate spacer 42, between a side surface of the line portion LP of the bit line BL and the intermediate spacer 42, and between a side surface of the contact portion CP of the bit line BL and the plug spacer 36, and may extend to cover a lower surface and an outer surface of the plug spacer 36.

The inner spacer 30 may include at least one of SiN and SiCN. The intermediate spacer 42 may include at least one of silicon oxide and a low-κ dielectric. Here, the low-κ dielectric may be a dielectric having a dielectric constant smaller than a dielectric constant of silicon oxide. According to one or more embodiments, the intermediate spacer 42 may be an air gap. The outer spacer 45 may include at least one of SiN and SiCN.

The semiconductor device 1 may further include contact structures CNT. The contact structures CNT may be formed of a conductive material. The contact structures CNT may be electrically connected to the second source/drain regions SD2 of the second active portions AF2.

Each of the contact structures CNT may include a lower conductive layer 55, an upper conductive layer 64 on the lower conductive layer 55, an intermediate conductive layer 61 between the lower conductive layer 55 and the upper conductive layer 64, and a pad pattern 75p on the upper conductive layer 64. The lower conductive layer 55 may be in contact with the second source/drain region SD2.

The lower conductive layer 55 may include doped polysilicon, for example, polysilicon having N-type conductivity. The intermediate conductive layer 61 may include a metal-semiconductor compound layer. The upper conductive layer 64 may include a conductive layer 64b and a barrier layer 64a covering a side surface and a bottom surface of the conductive layer 64b. The barrier layer 64a may include at least one of TiN, TaN, WN, TiSiN, TaSiN, or RuTiN, and the conductive layer 64b may include a metal material such as W. The pad pattern 75p may include at least one of Cu, Ti, Ta, Ru, W, Mo, Pt, Ni, Co, TiN, TaN, WN, NbN, TiAl, TiAlN, TiSi, TiSiN, TaSi, TaSiN, RuTiN, and NiSi. The pad pattern 75p may be disposed on a higher level (i.e., farther from the substrate SUB) than the bit line capping pattern BC and cover a portion of the upper surface of the adjacent bit line capping pattern BC.

In one example, the pad pattern 75p and the upper conductive layer 64 may be formed by different processes, so that a boundary surface may be formed between the lower surface of the pad pattern 75p and the upper surface of the upper conductive layer 64.

The semiconductor device 1 may further include an upper spacer 58 surrounding a side surface of the upper conductive layer 64. The upper spacer 58 may include an insulating material such as silicon oxide or silicon nitride.

The semiconductor device 1 may further include insulating fences IF that are parallel to each other. Each of the insulating fences IF may have a line shape extending in the X-direction. The insulating fences IF may vertically overlap the gate structures GS. The insulating fences IF may be formed of an insulating material such as silicon nitride or silicon oxide. The insulating fences IF may separate the contact structures CNT from the bit line capping pattern BC. Among the insulating fences IF, portions of the insulating fences IF that vertically overlap the bit lines BL may be disposed on a higher level (i.e., farther from the substrate SUB) than the bit lines BL and may penetrate through a portion of the bit line capping patterns BC.

The semiconductor device 1 may further include an insulating isolation pattern 78, an etch stop layer 85, and a data storage structure DS.

The insulating isolation pattern 78 may be disposed on side surfaces of the pad patterns 75p, and may extend downwardly. The insulating isolation pattern 78 may be disposed on a higher level (i.e., farther from the substrate SUB) than the bit lines BL. The etch stop layer 85 may be disposed on the insulating isolation pattern 78 and the pad patterns 75p, and may be formed of an insulating material.

In one or more embodiments, the data storage structure DS may be a capacitor storing information in a DRAM. For example, the data storage structure DS may be a capacitor of a DRAM including first electrodes 88 penetrating through the etch stop layer 85 and electrically connected to the contact structures CNT, a dielectric layer 90 covering the first electrodes 88 and the etch stop layer 85, and a second electrode 92 on the dielectric layer 90. The dielectric layer 90 may include a high dielectric, silicon oxide, silicon nitride, silicon oxynitride, or a combination thereof. The high dielectric may be a dielectric having a dielectric constant higher than the dielectric constant of silicon oxide.

In one or more embodiments, the data storage structure DS may be a structure storing information of a memory other than a DRAM. For example, in the data storage structure DS, the dielectric layer 90 may include a ferroelectric layer that can record data using a polarization state.

In one or more embodiments, by forming the upper surface of the first active portion AF1 to be convex upwardly, a contact area between the first source/drain region SD1 of the first active portion AF1 and the contact portion CP of the bit line BL may be increased. Accordingly, the contact resistance between the first source/drain region SD1 of the first active portion AF1 and the contact portion CP of the bit line BL may be reduced, thereby improving the performance of the semiconductor device.

In one or more embodiments, the first active portion AF1 may include the second region AP2 protruding upwardly from the first region AP1. Since the second region AP2 may minimize the vertical thickness of the contact portion CP of the bit line BL, the bit line BL including the contact portion CP may be formed without defects.

Hereinafter, various examples of modifications of the elements of the example embodiments described above will be described. The various examples of modifications of the elements of the above-described embodiment described below will be described with a focus on the modified or replaced elements. Here, the elements described above may be directly cited without a separate detailed description, or the description may be omitted. In addition, the elements that can be modified or replaced as described below are described with reference to the drawings below, but the elements that can be modified or replaced can be combined with each other or with the elements described above to form a semiconductor device according to one or more embodiments of the present disclosure.

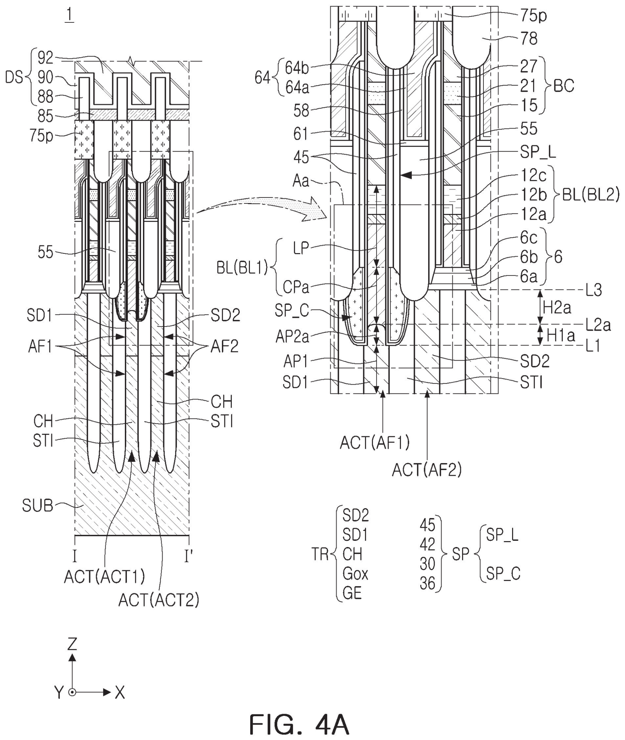

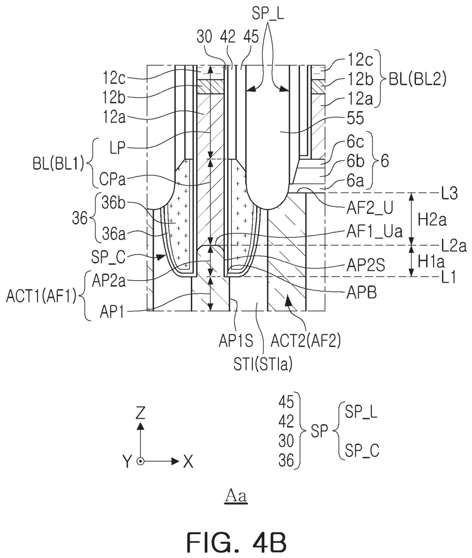

Referring to FIGS. 4A and 4B, an exemplary example of a semiconductor device according to one or more embodiments of the present disclosure will be described. FIG. 4A is a cross-sectional view illustrating a region taken along line I-I' of FIG. 1, and FIG. 4B is a partial enlarged view illustrating a region indicated by "Aa" in FIG. 4A.

In one or more embodiments, referring to FIGS. 4A and 4B, the contact portion (CP of FIGS. 2A and 2B) described above may be modified to form a contact portion CPa having an increased vertical length, and the second region (AP2 of FIGS. 2A and 2B) described above may be modified to form a second region AP2a having a decreased vertical length. Here, the vertical length may be a thickness in a vertical direction Z.

In one example, the vertical length of the contact portion CPa may be greater than the vertical length of the second region AP2a.

As described above, the bent portion APB may be disposed at the first level L1, and the upper surface AF2_U of the second active portion AF2 may be disposed at the third level L3.

An upper surface AF1a_U of the second vertical portion AP2a of the first active portion AF1 may be disposed at an intermediate level L2a.

In one example, a height difference H1a between the first level L1 and the intermediate level L2a may be equal to or less than a height difference H2a between the intermediate level L2a and the third level L3. For example, in FIG. 4B, it is illustrated that the height difference H1a between the first level L1 and the intermediate level L2a is less than the height difference H2a between the intermediate level L2a and the third level L3, but in one or more embodiments, height difference H1a between the first level L1 and the intermediate level L2a may be substantially equal to height difference H2a between the intermediate level L2a and the third level L3.

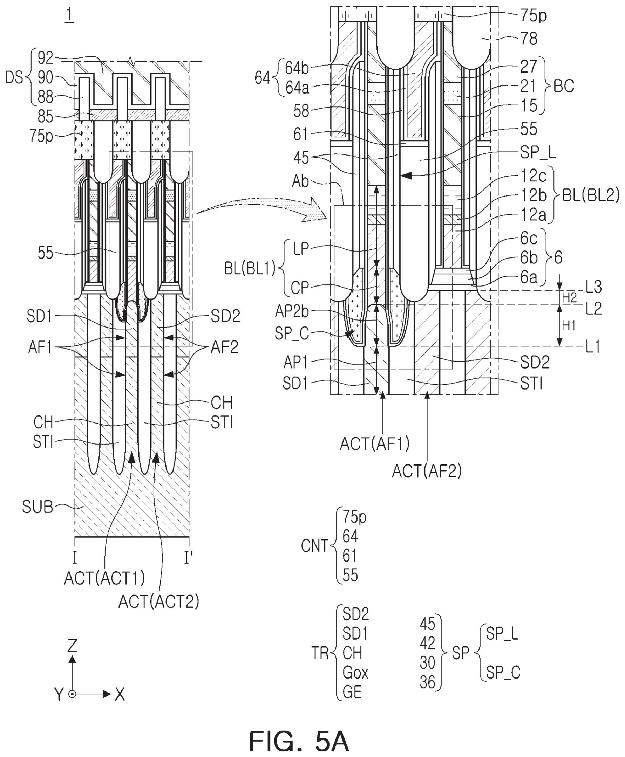

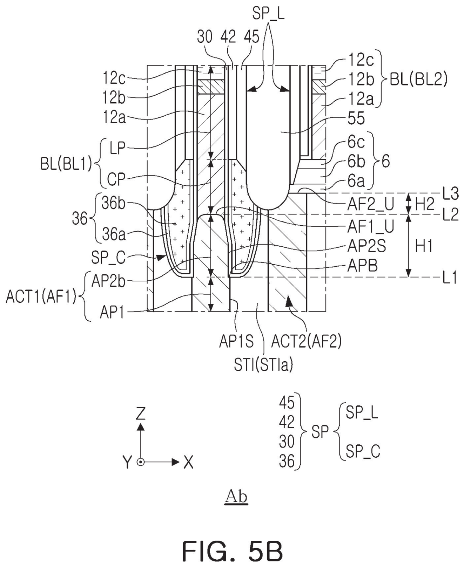

Referring to FIGS. 5A and 5B, an exemplary example of a semiconductor device according to one or more embodiments of the present disclosure will be described. FIG. 5A is a cross-sectional view illustrating a region taken along line I-I' of FIG. 1, and FIG. 5B is a partial enlarged view illustrating a region indicated by "Ab" of FIG. 5A.

In one or more embodiments, referring to FIGS. 5A and 5B, the second region (AP2 in FIGS. 2A and 2B) having substantially the same width as the contact portion CP described above may be modified to form a second region AP2b having a width greater than the width of the contact portion CP. An upper surface of the second region AP2b, which is upwardly convex, may contact the contact portion CP. In the X-direction, a width of the second region AP2b may be greater than the width of the contact portion CP. For example, a maximum width of the second region AP2b in the X-direction may be greater than a maximum width of the contact portion CP in the X-direction.

A width of a lower region of the second region AP2b may be greater than a width of an upper region of second region AP2b. In the X-direction, the width of the lower region of the second region AP2b may be greater than the width of the contact portion CP. Accordingly, the electrical characteristics of the first source/drain region SD1 formed within the second region AP2b may be improved.

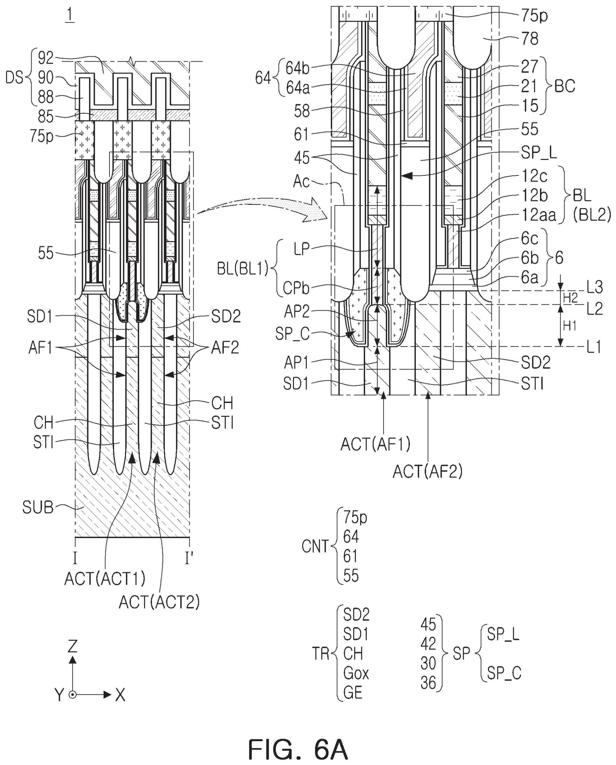

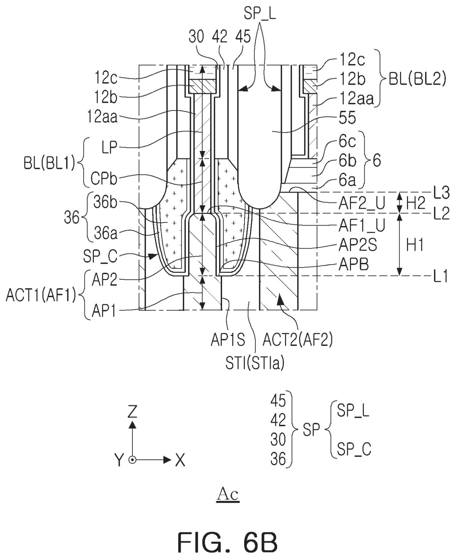

Referring to FIGS. 6A and 6B, an exemplary example of a semiconductor device according to one or more embodiments of the present disclosure will be described. FIG. 6A is a cross-sectional view illustrating a region taken along line I-I' of FIG. 1, and FIG. 6B is a partial enlarged view illustrating a region indicated by "Ac" in FIG. 6A.

In one or more embodiments, referring to FIGS. 6A and 6B, the first conductive layer (12a of FIGS. 2A and 2B) of the bit line BL described above can be transformed into a first conductive layer 12aa with a narrowed width. For example, the width of the first conductive layer 12aa of the bit line BL may be smaller than a width of each of the second and third conductive layers 12b and 12c of the bit line BL.

The contact portion (CP of FIGS. 2A and 2B) described above may be transformed into a contact portion CPb with a narrowed width. Therefore, in the X-direction, a width of the contact portion CPb may be smaller than a width of the second region AP2.

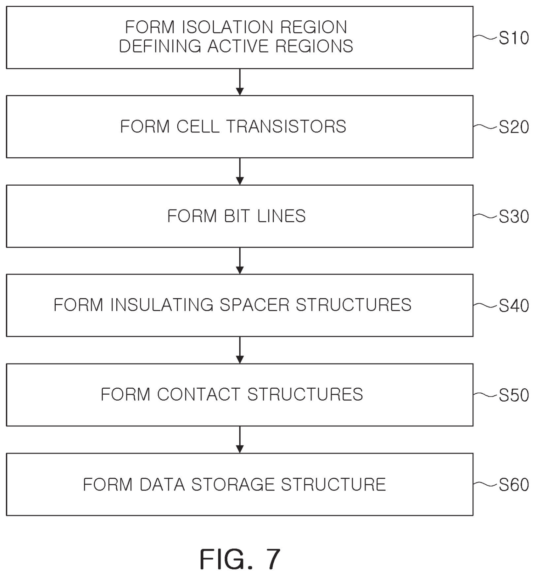

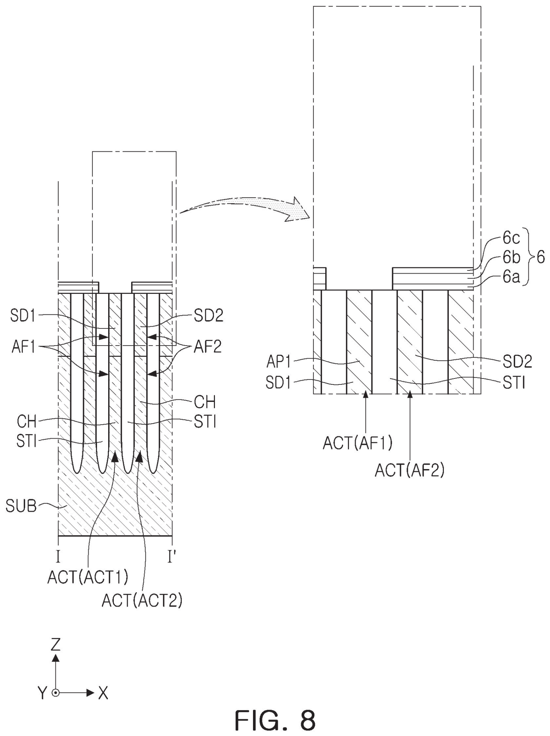

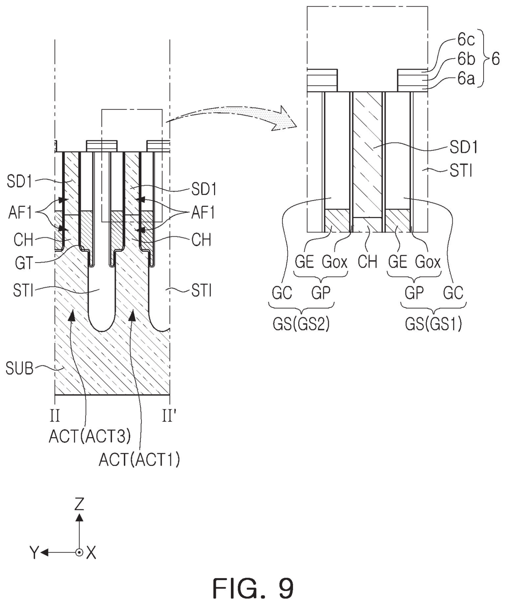

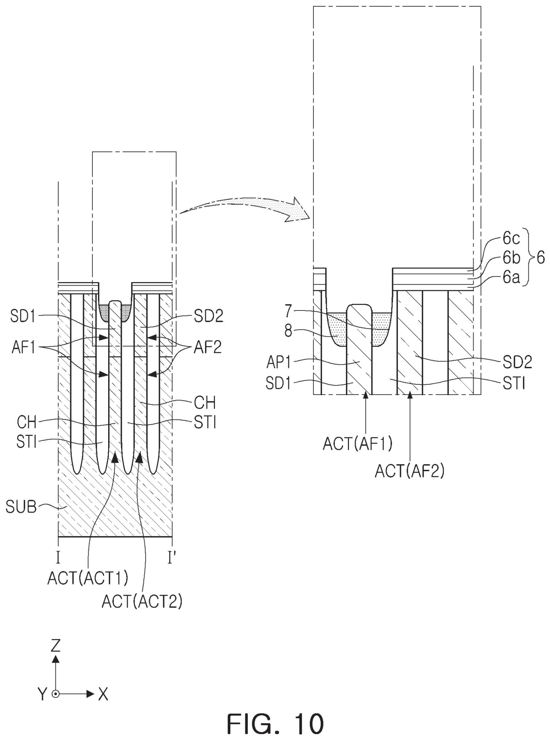

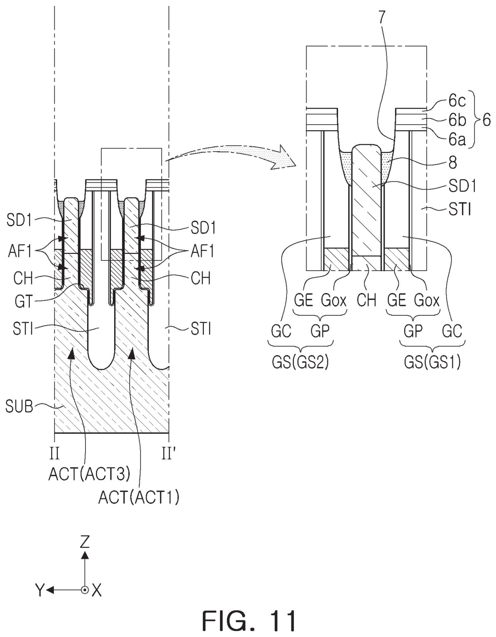

Next, with reference to FIGS. 1A, 2B, and 7 to 16, an exemplary method for forming a semiconductor device according to one or more embodiments of the present disclosure will be described. FIG. 7 is a process flow diagram for illustrating an exemplary example of a method for forming a semiconductor device according to one or more embodiments of the present disclosure, and FIGS. 8 to 16 are cross-sectional views for illustrating an exemplary example of a method for forming a semiconductor device according to one or more embodiments of the present disclosure. In FIGS. 7 to 16, FIGS. 8, 10, 12, 14, 15, and 16 are cross-sectional views taken along line I-I' of FIG. 1A, and FIGS. 9, 11, and 13 are cross-sectional views taken along line II-II' of FIG. 1A.

Referring to FIGS. 1A, 1B, 7, 8 and 9, an isolation region STI defining active regions ACT may be formed (S10). The active regions ACT and the isolation region STI may be formed on a substrate SUB. The isolation region STI may be formed on side surfaces of the active regions ACT. The active regions ACT may be arranged as in FIG. 1A and FIG. 1B. For example, each of the active regions ACT may have a bar shape extending in a D-direction. The active regions ACT may be formed of a semiconductor material such as single crystal silicon. The isolation region (STI) may be formed of an insulating material. The isolation region (STI) may be a shallow trench isolation.

Cell transistors TR may be formed (S20). Forming the cell transistors TR may include forming gate trenches GT crossing the isolation region STI and the active regions ACT, and forming gate structures GS within the gate trenches GT. Each of the gate structures GS may have a line shape extending in an X-direction.

Each of the gate structures GS may include a gate pattern GP and a gate capping layer GC on the gate pattern GP. Each of the gate patterns GP may include a gate dielectric layer Gox and a gate electrode GE. In each of the gate patterns GP, the gate dielectric layer Gox may be formed on an inner wall of the gate trench GT, and the gate electrode GE may partially fill the gate trench GT on the gate dielectric layer Gox. The gate capping layer GC may fill the remaining portion of the gate trench GT on the gate electrode GE. The gate capping layer GC may be formed of an insulating material such as silicon nitride, or the like. The gate dielectric layer Gox may extend from a portion disposed between the gate electrode GE and the inner wall of the gate trench GT to a point between the gate capping layer GC and the inner wall of the gate trench GT.

Forming the cell transistors TR may further include forming a channel region CH, and first and second source/drain regions SD1 and SD2. The channel region CH, and the first and second source/drain regions SD1 and SD2 may be formed within each of the active regions ACT. Accordingly, each of the active regions ACT may include the channel region CH and the first and second source/drain regions SD1 and SD2. In one of the active regions ACT, the first and second source/drain regions SD1 and SD2 may be formed within an upper region of the active region ACT, and the channel region CH may be formed within the active region ACT below the first and second source/drain regions SD1 and SD2 and within the active region ACT below the gate structure GS.

Each of the cell transistors TR may include the gate electrode GE, the gate dielectric layer Gox, and the channel region CH, the first and second source/drain regions SD1 and SD2.

Among the gate structures GS, a pair of gate structures GS adjacent to each other may extend across each of the active regions ACT and into the isolation region STI. For example, each of the active regions ACT may include active portions AF1 and AF2, spaced apart from each other by the adjacent pair of gate structures GS.

In each of the active regions ACT, the active portions AF1 and AF2 may include second active portions AF2 spaced apart from each other in the D-direction and a first active portion AF1 disposed between the second active portions AF2.

A buffer insulating structure 6 may be formed. The buffer insulating structure 6 may include a first insulating layer 6a, a second insulating layer 6b, and a third insulating layer 6c, which are sequentially stacked. The first and third insulating layers 6a and 6c may be formed of silicon oxide, and the second insulating layer 6b may be formed of silicon nitride.

The buffer insulating structure 6 may cover the active regions ACT, the isolation region STI, and the gate structures GS, and may not cover the first source/drain regions SD1 of the first active portions AF1. Accordingly, the first source/drain regions SD1 of the first active portions AF1 may be exposed. The buffer insulating structure 6 may expose a portion of an upper surface of the first source/drain region SD1 and the isolation region STI adjacent to the first source/drain region SD1, and a portion of an upper surface of each of the gate structures GS adjacent to the first source/drain region SD1.

Referring to FIGS. 1A, 1B, 7, 10, and 11, the isolation region STI and the gate structures GS that are exposed and not covered by the buffer insulating structure 6 may be partially etched to form a recessed region 7, and at the same time, a portion of the first active portion AF1 may be etched to lower the height thereof, and an edge of the upper surface of the first active portion AF1 may be etched to form the upwardly convex upper surface of the first active portion AF1. Accordingly, the upper surface of the first active portion AF1 may be formed on a lower level than an upper surface of the second active portion AF2, and the upper surface of the first active portion AF1 may have an upwardly convex curved shape. The upper surface of the second active portion AF2 may have a substantially flat shape.

An insulating pattern 8 partially filling the recessed region 7 may be formed, where the insulating pattern 8 leaves the upper surface of the first active portion AF1 exposed. The insulating pattern 8 may be formed of an insulating material such as silicon oxide or silicon nitride.

Referring to FIGS. 1A, 1B, 7, 12, and 13, at least one conductive layer (12a, 12b, 12c) and at least one insulating layer (15, 21, 27) may be formed.

The at least one conductive layer (12a, 12b, 12c) may include a first conductive layer 12a, a second conductive layer 12b, and a third conductive layer 12c that are sequentially stacked. The first conductive layer 12a may be formed on the buffer insulating structure 6, the insulating pattern 8, and the first active portion AF1. The first conductive layer 12a may be in contact with the first active portion AF1 while filling the recessed region 7. The at least one insulating layer (15, 21, 27) may include a first insulating material layer 15, a second insulating material layer 21, and a third insulating material layer 27 that are sequentially stacked.

Referring to FIGS. 1A, 1B, 7, and 14, bit lines BL may be formed (S30). Forming the bit lines BL may include patterning the at least one conductive layer (12a, 12b, 12c) and the at least one insulating layer (15, 21, 27).

The at least one conductive layer (12a, 12b, 12c) may be patterned and formed into the bit lines BL. The at least one insulating layer (15, 21, 27) may be patterned and formed into bit line capping patterns BC. Each of the bit lines BL may have a shape of a line extending in a Y-direction. The bit line BL may be formed to contact an upper surface of the first active portion AF1.

In one or more embodiments, the first active portion AF1 may be formed in a shape protruding from a bottom surface of the recessed region 7, and the insulating pattern 8 may be formed to cover a side surface of the protruding portion of the first active portion AF1 from the bottom surface of the recessed region 7. Due to the portion of the first active portion AF1 protruding from the bottom surface of the recessed region 7, and the insulating pattern 8, a process of patterning the at least one conductive layer (12a, 12b, 12c) for forming the bit lines BL may be performed without defects. For example, since the at least one conductive layer (12a, 12b, 12c) does not completely fill the recessed region 7 but partially fills the recessed region 7, the at least one conductive layer (12a, 12b, 12c) located in the recessed region 7 may be patterned without defects. Since the first active portion AF1 may be formed in a shape protruding from the bottom surface of the recessed region 7, the bit line BL may be formed without defects.

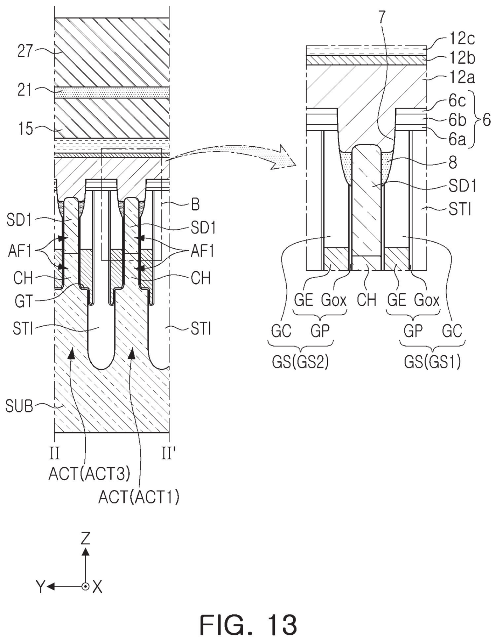

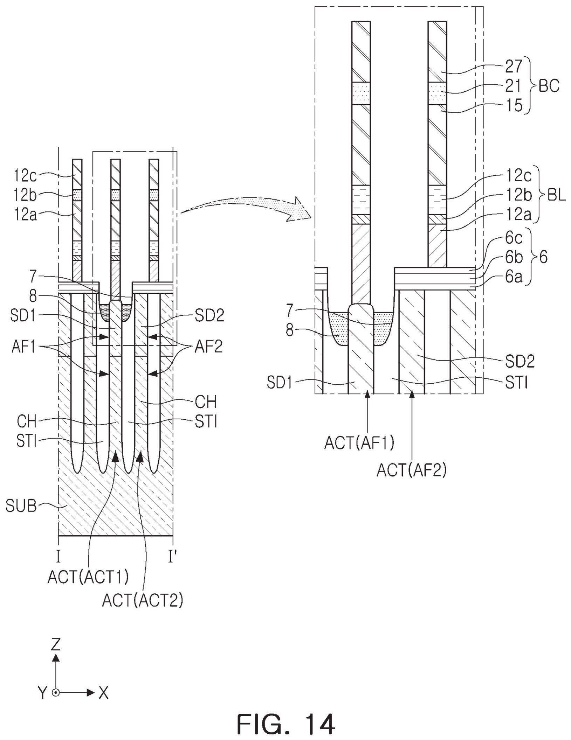

Referring to FIGS. 1A, 1B, 7, and 15, the insulating pattern (insulating pattern 8 of FIG. 14) not covered by the bit line BL may be removed by an etching process. Therefore, the insulating pattern (insulating pattern 8 of FIG. 14) may be removed, and the insulating pattern (insulating pattern 8 of FIG. 13) covered by the bit line BL may remain.

In order to increase the separation distance between the second source/drain region SD2 in the second active portion AF2 and the first source/drain region SD1 in the first active portion AF1 while removing the insulating pattern (insulating pattern 8 in FIG. 14), a portion of the first active portion AF1 may be etched. Therefore, the first active portion AF1 may include a protruding region P1 protruding from the isolation region STI and having a lower region having a larger width than an upper region.

Referring to FIGS. 1A, 1B, 7, and 16, in order to further increase a separation distance between the second source/drain region SD2 within the second active portion AF2 and the first source/drain region SD1 within the first active portion AF1 while removing the first conductive layer 12a, which is not disposed below the bit line BL and remains within the recessed region 7, a portion of the first active portion AF1 may be etched. Accordingly, it is possible to form a first active portion AF1 including the first region (first region AP1 of FIG. 2B) and the second region (second region AP2 of FIG. 2B) as described above in FIGS. 2A and 2B.

In one or more embodiments, in order to prevent the first conductive layer 12a from remaining in a region in which the bit line BL is not formed while forming the first active portion AF1, the first conductive layer 12a may be over-etched to form a first conductive layer (layer 12aa in FIGS. 6A and 6B) as in FIGS. 6A and 6B.

In one or more embodiments, by controlling an etching process for etching a portion of the first active portion AF1, it is also possible to form a first active portion AF1 including a second region (second region AP2b in FIG. 5B) in which the width of the lower region is larger than the width of the upper region, as in FIG. 5A and FIG. 5B.

Referring to FIGS. 1A, 1B, 2A, 2B, 3, and 7, insulating spacer structures SP may be formed (S40). Forming the insulating spacer structures SP may include forming an inner spacer 30, forming a plug spacer 36, forming an intermediate spacer 42, and forming an outer spacer 45. The inner spacer 30 may conformally cover an inner wall of the recessed region 7 while conformally covering the buffer insulating structure 6, not covered by the bit lines BL, side surfaces of the bit lines BL, and side surfaces of the bit line capping patterns BC. The plug spacer 36 may be formed to fill the recessed region 7 on the inner spacer 30. The plug spacer 36 may include a spacer pattern 36b and a spacer liner 36a covering a side surface and a lower surface of the spacer pattern 36b. The intermediate spacer 42 and the outer spacer 45 may be formed sequentially on the line portions LP of the bit lines BL and the side surfaces of the bit line capping patterns BC. Insulating fences IF may be formed. The insulating fences IF may be formed to partially penetrate the bit line capping patterns BC and extend between the bit lines BL. Contact structures CNT may be formed (S50). Forming a first material layer filling between bit line structures BL and BC including the bit lines BL and the bit line capping patterns BC, forming the insulating fences IF to separate the first material layer from each other in the X-direction, partially etching the separated first material layer are to form a lower conductive layer 55, forming an upper spacer 58 on a side surface of an empty space above the lower conductive layer 55, performing a silicide process to form an intermediate conductive layer 61 on the lower conductive layer 55, forming an upper conductive layer 64 on the intermediate conductive layer 61, and forming a pad pattern 75p on the upper conductive layer 64. An insulating isolation pattern 78 passing between the pad patterns 75p of the contact structures CNT may be formed, and an etch stop layer 85 may be formed on the pad patterns 75p and the insulating isolation pattern 78. A data storage structure DS may be formed (S60). The data storage structure DS may include first electrodes 88 penetrating through the etch stop layer 85 and electrically connected to the pad patterns 75p of the contact structures CNT, a dielectric layer 90 covering the first electrodes 88 and the etch stop layer 85, and a second electrode 92 on the dielectric layer 90.

In one or more embodiments, since the first active portion AF1 may be formed to protrude from a bottom surface of the recessed region 7, for example, the first active portion AF1 including the second region (second region AP2 of FIG. 2B) may be formed, the bit line BL may be formed without defects.

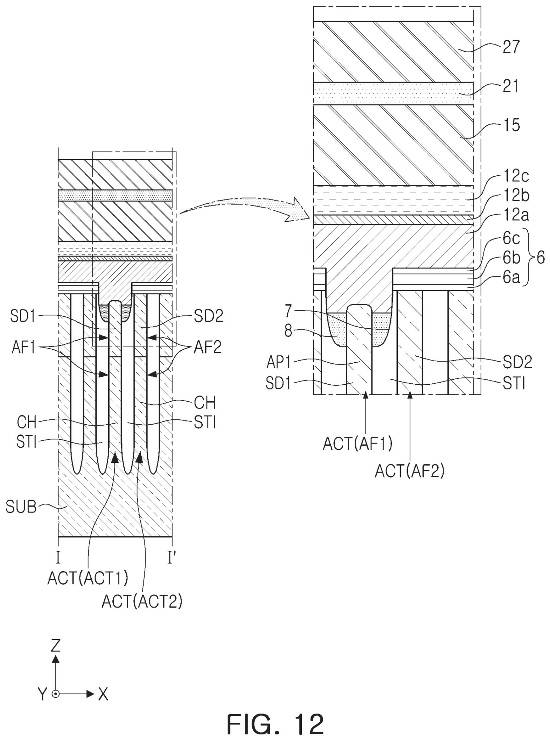

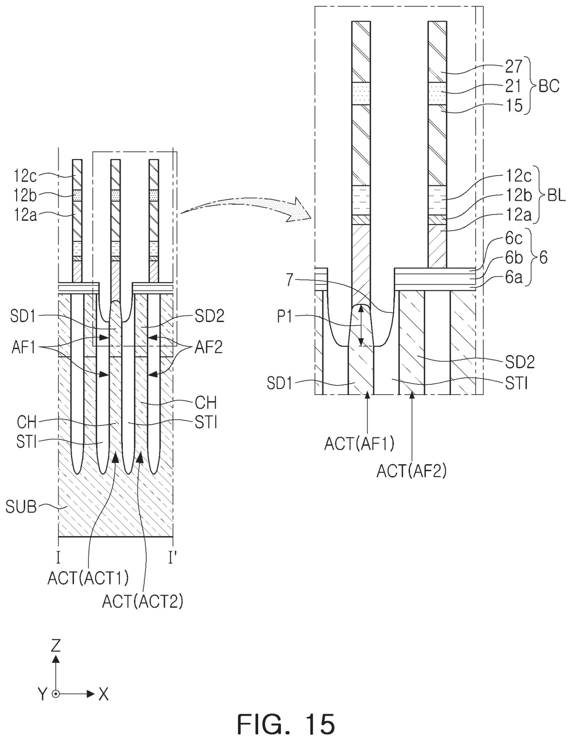

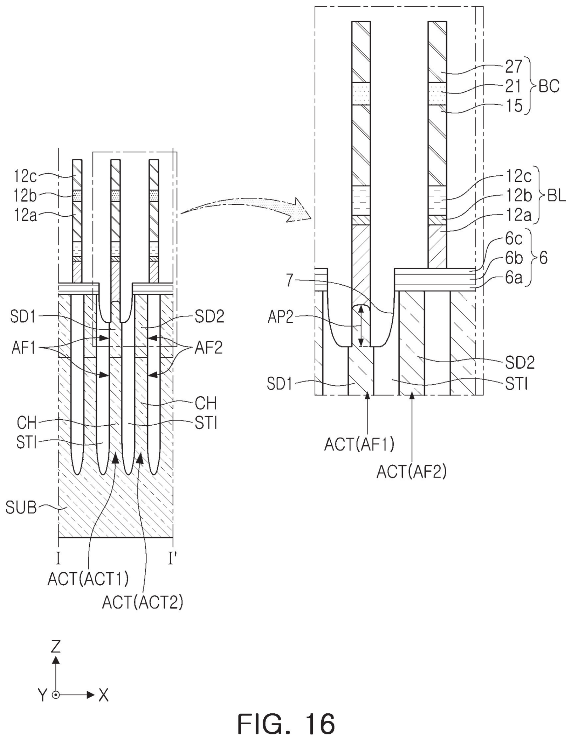

In one or more embodiments, while a process for increasing a separation distance between the second source/drain region SD2 within the second active portion AF2 and the first source/drain region SD1 within the first active portion AF1 is performed as in FIGS. 15 and 16, the at least one conductive layer (layers 12a, 12b, 12c in FIG. 12) in a region in which the bit line BL is not formed may be completely removed so that no portion remains. Accordingly, after forming the bit line BL, it is possible to prevent defects caused by a conductive material of the at least one conductive layer (layers 12a, 12b, 12c of FIG. 12) remaining in the region in which the bit line BL is not formed.

In one or more embodiments, by increasing the separation distance between the second source/drain region SD2 within the second active portion AF2 and the first source/drain region SD1 within the first active portion AF1, leakage current between the second source/drain region SD2 within the second active portion AF2 and the first source/drain region SD1 within the first active portion AF1 may be prevented, and parasitic capacitance between the second source/drain region SD2 within the second active portion AF2 and the first source/drain region SD1 within the first active portion AF1 may be reduced, thereby improving the performance of the semiconductor device.

As set forth above, according to one or more embodiments, a semiconductor device including an active portion including a first region having a side surface in contact with an isolation region and second region extending upwardly from the first region, and spaced apart from the isolation region, and a bit line including a contact portion connected to the second region of the active portion may be provided.

In one or more embodiments, by forming the active portion including the second region protruding from the isolation region, it is possible to prevent defects occurring during a patterning process for forming the bit line.

In one or more embodiments, by forming an upper surface of the active portion into a convex shape upwardly, a contact area between the active portion and the contact portion of the bit line may be increased. Accordingly, since the resistance between a source/drain region formed in the active portion and the bit line may be reduced, the performance of the semiconductor device may be improved.

Even if a size of the active portion and bit line is reduced, a degree of integration of the semiconductor device may be improved because the active portion and bit line can be provided to prevent defects and improve performance as described above.

The various aspects and features of the present disclosure are not limited to the above-described content, and can be more easily understood through description of specific embodiments of the present disclosure.

While example embodiments have been illustrated and described above, it will be apparent to those skilled in the art that modifications and variations could be made without departing from the scope of the present disclosure as defined by the appended claims.

## Claims

1. A semiconductor device comprising:
a first active portion (AF1);
an isolation region (STI) on a side surface of the first active portion (AF1); and
a bit line (BL) connected to the first active portion (AF1),
wherein the first active portion (AF1) comprises a first region (AP1) in contact with the isolation region (STI) and a second region (AP2) extending upwardly from the first region (AP1), wherein the second region (AP2) is spaced apart from the isolation region (STI), and
wherein the bit line (BL) comprises:
a line portion (LP) extending in a horizontal direction (Y); and
a contact portion (CP) below the line portion (LP), wherein the contact portion (CP) is connected to the second region (AP2) of the first active portion (AF1).

2. The semiconductor device of claim 1, further comprising:
an insulating spacer structure (SP) comprising a contact spacer (SP_C) and a line spacer (SP_L),
wherein the contact spacer (SP_C) is on a side surface of the second region (AP2) of the first active portion (AF1) and a side surface of the contact portion (CP), and
wherein the line spacer is on a side surface of the line portion (LP).

3. The semiconductor device of claim 2, wherein a width of the contact spacer (SP_C) is greater than a width of the line spacer (SP_L).

4. The semiconductor device of claim 2 or 3,
wherein the isolation region (STI) is in contact with a side surface of the first region (AP1) of the first active portion (AF1), and
wherein the contact spacer (SP_C) is in contact with the side surface of the second region (AP2) of the first active portion (AF1) and the side surface of the contact portion (CP).

5. The semiconductor device of any one of claims 1 to 4, wherein the contact portion (CP) extends from the line portion (LP).

6. The semiconductor device any one of claims 1 to 5,
wherein the line portion (LP) comprises a first conductive layer (12a), a second conductive layer (12b), and a third conductive layer (12c),
wherein the first conductive layer (12a), the second conductive layer (12b), and the third conductive layer (12c) are sequentially stacked,
wherein the contact portion (CP) extends from the first conductive layer (12a) of the line portion (LP), and
wherein the first conductive layer (12a) comprises doped polysilicon.

7. The semiconductor device of any one of claims 1 to 6, wherein the side surface of the first active portion (AF1) has a bent portion (APB) between a side surface (AP1S) of the first region (AP1) and a side surface (AP2S) of the second region (AP2).

8. The semiconductor device of any one of claims 2 to 7, further comprising:
a second active portion (AF2) adjacent to the first active portion (AF1) and spaced apart from the first active portion (AF1) by the isolation region (STI),
wherein an upper surface (AF2_U) of the second active portion (AF2) is at a first height level (L3),
wherein an upper surface (AF1_U) of the second region (AP2) of the first active portion (AF1) is at a second height level (L2),
wherein a region between a side surface (AP1S) of the first region (AP1) of the first active portion and a side surface (AP2S) of the second region (AP2) of the first active portion (AF1) is at a third height level (L1), and
wherein the second height level (L2) is at a lower level than the first height level (L3).

9. The semiconductor device of claim 8,
wherein the isolation region (STI) is between the first region (AP1) of the first active portion (AF1) and the second active portion (AF2), and
wherein the isolation region (STI) extends from a portion between the first region (AP1) of the first active portion (AF1) and the second active portion (AF2) to a point between the contact spacer (SP_C) and the second active portion (AF2).

10. The semiconductor device of claim 8 or 9, wherein in the first active portion (AF1), a vertical thickness of the second region (AP2) is greater than a width of the second region (AP2).

11. The semiconductor device of any one of claims 8 to 10, further comprising:
a contact structure (CNT) on the second active portion (AF2); and
a data storage structure (DS) on the contact structure (CNT),
wherein a lower surface of the contact structure (CNT) is at a higher level than the upper surface (AF1_U) of the first active portion (AF1).

12. The semiconductor device of any one of claims 8 to 11, further comprising:
a gate structure (GS),
wherein the gate structure (GS) comprises:
a gate electrode (GE);
a gate capping pattern (GC) on the gate electrode (GE); and
a gate dielectric layer (Gox) on a side surface and a lower surface of the gate electrode (GE), and
wherein the first active portion (AF1) and the second active portion (AF2) are spaced apart from each other by the gate structure (GS).

13. The semiconductor device of claim 12, further comprising:
an insulating pattern (8),
wherein the insulating pattern (8) is between the gate capping pattern of the gate structure (GS) and the first active portion (AF1), and
wherein the contact portion (CP) of the bit line (BL) comprises a portion contacting the first active portion (AF1) and a portion contacting the insulating pattern (8).

14. The semiconductor device of any one of claims 1 to 13, wherein an upper surface (AF1_U) of the first active portion (AF1) is upwardly convex.

15. The semiconductor device of claim 14, wherein the contact portion (CP) of the bit line (BL) is in contact with the upper surface (AF1_U) of the first active portion (AF1).
